Europäisches Patentamt

European Patent Office

Office européen des brevets

(19)

(11) Veröffentlichungsnummer: **0 130 587 B1**

(12) **EUROPÄISCHE PATENTSCHRIFT**

(45) Veröffentlichungstag der Patentschrift: 06.11.91

(51) Int. Cl.⁵: **H03K 3/353**, H03K 19/094

(21) Anmeldenummer: 84107518.7

(22) Anmeldetag: 28.06.84

(54) **Eingangssignalpegelwandler für eine MOS-Digitalschaltung.**

(30) Priorität: 29.06.83 DE 3323446

(43) Veröffentlichungstag der Anmeldung:
09.01.85 Patentblatt 85/02

(45) Bekanntmachung des Hinweises auf die
Patenterteilung:
06.11.91 Patentblatt 91/45

(84) Benannte Vertragsstaaten:
AT DE FR GB IT

(56) Entgegenhaltungen:
WO-A-82/00930

PATENT ABSTRACTS OF JAPAN, Band 4, Nr.
32 (E-2)[514], 19. März 1980; & JP-A-55 5563
(NIPPON DENKI K.K.) 16-01-1980

IBM TECHNICAL DISCLOSURE BULLETIN,
Band 19, Nr. 3, 3. August 1976, Seiten
827-828, New York, US; T.V. HARROUN:
"Bootstrap inverter driver"

(73) Patentinhaber: SIEMENS AKTIENGESELL-
SCHAFT
Wittelsbacherplatz 2
W-8000 München 2(DE)

(72) Erfinder: Bähring, Manfred, Dipl.-Ing.
Valerystrasse 25
W-8044 Unterschleissheim(DE)

## Beschreibung

Die Erfindung befaßt sich mit einem Eingangssignalpegelwandler für eine MOS-Digitalschaltung, der zusammen mit der MOS-Digitalschaltung in n-Kanal-MOS-Technik aufgebaut ist, bei der der durch ein TTL-Signal beaufschlagte Signaleingang zur Steuerung eines ersten und eines zweiten MOS-Feldeffekttransistors dient, wobei der Sourceanschluß des ersten MOS-Feldeffekttransistors an dem das Bezugspotential führenden Versorgungsanschluß und sein Drainanschluß einerseits am Sourceanschluß des zweiten MOS-Feldeffekttransistors liegt und andererseits über die Source-Drainstrecke eines dritten MOS-Feldeffekttransistors mit dem das Versorgungspotential liefernden Versorgungsanschluß verbunden ist, bei dem außerdem der Drainanschluß des zweiten MOS-Feldeffekttransistors einerseits den Signalausgang des Wandlers bildet und andererseits über die Parallelschaltung eines vierten MOS-Feldeffekttransistors mit der Reihenschaltung eines Bootstrap-Kondensators und eines als Widerstand geschalteten fünften MOS-Feldeffekttransistors mit dem das Versorgungspotential liefernden Versorgungsanschluß verbunden ist und bei dem schließlich der Signalausgang unmittelbar mit dem Signaleingang der das gleiche Bezugspotential und das gleiche Versorgungspotential wie der Signalpegelwandler verwendeten MOS-Digitalschaltung verbunden ist.

Aus der Druckschrift IBM Technical Disclosure Bulletin, Vol. 19, No. 3, August 1976, S. 827 f. ist eine Bootstrap-Treiberschaltung für kapazitive Lasten bekannt, mit der ein Ausgangspegel von VDD erreicht werden kann. Der Bootstrap-Transistor T4 liegt mit seinem Steuereingang nicht direkt am Bootstrap-Kondensator, sondern an einem Spannungsteiler, der zwischen VDD und Masse liegt und vom Eingangssignal gesteuert wird. Ein denkbarer Einsatz als Signalpegelwandler für TTL-Eingangssignale erfordert eine sorgfältige Dimensionierung der Transistoren, um überhaupt einen Bootstrap-Effekt zu realisieren. Selbst dann ist die Schaltung als Signalpegelwandler praktisch nicht brauchbar, da sie keine Schmitt-Trigger-Eigenschaften aufweist, was zu einer hohen Störanfälligkeit gegenüber Rauschsignalen auf dem Eingangssignal führt. Die bekannte Schaltung besitzt zwar einen vergleichsweise geringen Ruhestrom; dies geht aber auf Kosten der Signalverzögerungszeit, da das Gate von T4 bei einem Umschaltvorgang von 0 Volt an gemäß der unvermeidlichen Zeitkonstanten aufgeladen werden muß.

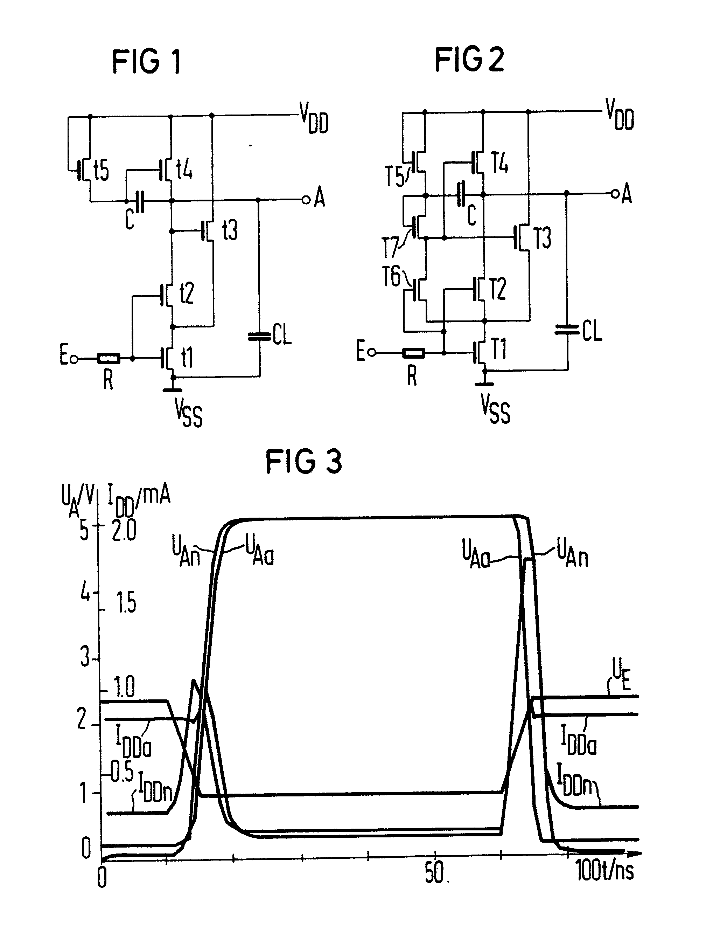

Eine bekannte Schaltung für einen Eingangssignalpegelwandler entsprechend der eingangs gegebenen Definition ist in Figur 1 dargestellt. Um die zur vorliegenden Erfindung führende Aufgabe näher beschreiben zu können, empfiehlt es sich, zunächst die als Schmitt-Trigger arbeitende Schaltung gemäß Figur 1 zu beschreiben. Sie ist bevorzugt mit n-Kanal-MOS-Feldeffekttransistoren vom selbstsperrenden Typ aufgebaut.

Der Signaleingang E der bekannten Schaltung liegt, insbesondere über einen Vorwiderstand R, am Gate eines ersten MOS-Feldeffekttransistors t1 Und am Gate eines zweiten MOS-Feldeffekttransistors t2. Dabei liegt der Sourceanschluß des ersten Transistors t1 an der das Bezugspotential $V_{ss}$ führenden Versorgungsklemme und sein Drain am Sourceanschluß des genannten zweiten MOS-Feldeffekttransistors t2 sowie am Sourceanschluß eines dritten MOS-Feldeffekttransistors t3. Der Drainanschluß des zweiten MOS-Feldeffekttransistors t2 ist einerseits mit dem Gate des dritten MOS-Transistors t3 verbunden und bildet andererseits - zusammen mit dem Sourceanschluß des vierten MOS-Feldeffekttransistors t4-den Signalausgang A des Pegelwandlers. Der genannte vierte MOS-Feldeffekttransistor t4 liegt mit seinem Drain an der das Versorgungspotential $V_{DD}$ führenden Versorgungsklemme und mit seinem Gate am Sourceanschluß eines fünften MOS-Feldeffekttransistors t5, dessen Drain und dessen Gate mit der Klemme für das Versorgungspotential $V_{DD}$ verbunden ist. Die Verbindung zwischen dem Gate und der Source des vierten Transistors t4 ist durch einen MOS-Kondensator C realisiert, der zu einer Bootstrap-Wirkung führt. Schließlich kann noch der Signalausgang A mit der Klemme für das Bezugspotential $V_{ss}$ durch einen (ggf. parasitären) Lastkondensator CL verbunden sein, der z.B. durch die zu steuernde MOS-Digitalschaltung gegeben ist. Diese wird ebenfalls durch das Versorgungspotential $V_{DD}$ und das Bezugspotential $V_{ss}$ beaufschlagt und liegt mit ihrem Signaleingang am Signalausgang A des Pegelwandlers. Vorzugsweise ist der Pegelwandler mit der (in den Figuren nicht dargestellten) digitalen MOS-Schaltung monolithisch zusammengefaßt. Der Drain des dritten Transistors t3 liegt am Potential $V_{DD}$.

Es läßt sich nun im Zusammenhang mit der bekannten Schaltung gemäß Figur 1 folgendes feststellen. Die Schaltung dient der Aufgabe, die von einer bipolaren TTL-Logik gelieferten Daten für die Beaufschlagung einer MOS-Digitalschaltung, z.B. eines dynamischen RAM-Speichers, verwenden zu können. Die Standardpegel der vom Ausgang einer TTL-Logik gelieferten digitalen Signale liegen im High-Zustand minimal bei 2,4 V und im Low-Zustand bei maximal 0,8 V. Für eine n-Kanal-MOS-Schaltung ist der Pegel $U_{A\ max} = V_{DD}$ und der Pegel $U_{A\ min}$ etwa gleich 0 V. Die Pegelwandlung soll mit möglichst geringer Verlustleistung und möglichst geringer Verzögerung durchgeführt werden.

Angestrebt ist eine Pegelwandlerschaltung mit geringer Eingangskapazität und mit einer möglichst niedrigen Ausgangs-Low-Spannung (auf $V_{ss}$ bezogen).

Die in Figur 1 dargestellte Schaltung gewährleistet nun, daß auch bei einer Signaleingangsspannung $U_E = 0,8$ V und $U_T<0,8$ V die Ausgangsspannung $U_A = V_{DD}$ wird. Durch den Bootstrap-Kondensator C erhält das Gate des den Signalausgang A mit dem Versorgungspotential $V_{DD}$ verbindenden Transistors t4 eine genügend hohe Spannung, um während des gesamten Umschaltvorgangs den Transistor t4 im Anlaufgebiet zu halten. Dadurch kann die Ausgangsspannung $U_A$ des Wandlers den Wert $V_{DD}$ erhalten. Außerdem wird der dynamische Umladevorgang der Lastkapazität CL günstig beeinflußt, weil der Innenwiderstand eines MOS-Transistors im Anlaufgebiet ja geringer ist als im Sättigungsgebiet.

Die Vorladung des Bootstrap-Kondensators C auf den Spannungswert $U_C = V_{DD} - U_T$ ($U_T$ = Schwellspannung des MOS-Feldeffekttransistors) führt jedoch zu zwei nachteiligen Erscheinungen, nämlich

a) Da die Gatespannung des MOS-Transistors t4 im Ruhezustand ($U_E$ = High) schon relativ hoch ist ( $U_G = V_{DD} - U_T$) und andererseits die Ausgangsspannung $U_A$ jedoch möglichst gering sein soll, ergibt sich ein ungünstiges Größenverhältnis von t4 zu t2 und t1 von etwa 1 zu 10 - 20 für $U_A<0,5$ V (Faustformel: t4 mit 1 W/L = >t2/ t1 mit 10 - 20 W/L.) b) Da das dynamische Verhalten bei schnellen Flanken von Eingangssignalen $U_E$ durch den Transistor t4 und durch den Lastkondensator CL bestimmt wird, gehört zu einer gegebenen Flankensteilheit $t_r$ der Ausgangsspannung und einer gegebenen Lastkapazität CL ein relativ hoher Ruhestrom, der im wesentlichen durch den Transistor t4 bestimmt wird. Außerdem hat man eine durch die Gatekapazität von t1 und t2 bestimmte Eingangskapazität. Diese kann in Verbindung mit einem z.B. durch eine Eingangsschutzstruktur der monolithisch integrierten Schaltung bedingten Vorwiderstand R eine merkliche Verzögerung des Ausgangssignals $U_A$ relativ zu dem auslösenden Eingangssignal $U_E$ bewirken.

Aufgabe der Erfindung ist es nun, eine der eingangs gegebenen Definition entsprechende Schaltung für einen Eingangssignalpegelwandler anzugeben, die in der Lage ist, die beiden genannten Hauptnachteile der bekannten Schaltung zu umgehen oder wenigstens zu mildern, ohne jedoch bei den sonstigen Eigenschaften des Pegelwandlers, insbesondere seinem dynamischen Verhalten, eine Verschlechterung in Kauf nehmen zu müssen. Dazu müssen zwei Probleme gelöst werden, nämlich

1. Im Ruhezustand (d.h. $U_E$ High) muß die Gatespannung des vierten Transistors, also des Transistors t4, merklich gesenkt werden. Dies bedeutet, daß der über den Pegelwandler fließende Versorgungsstrom kleiner wird. Außerdem können dann der erste und der zweite Transistor, also die beiden Eingangstransistoren t1 und t2, bei einer dem Low-Pegel am Signalausgang A entsprechenden maximalen Ausgangsspannung $U_{A\ Lo\ max}$ kleiner bemessen werden, so daß schließlich die Eingangskapazität $C_{In}$ vermindert wird.

2. Andererseits ist eine möglichst hohe Vorladung der Bootstrap-Kapazität C erwünscht, um die Spannung am Gate des vierten Transistors, also des Transistors t4 bei der in Figur 1 gezeigten Schaltungsstruktur, beim Umschaltvorgang genügend zu überhöhen.

Um den eingangs definierten Pegelwandler in dem angegebenen Sinne zu verbessern, wird gemäß der vorliegenden Erfindung ein sechster und ein siebenter MOS-Feldeffekttransistor vorgesehen und dabei der Sourceanschluß des sechsten MOS-Feldeffekttransistors mit dem Drainanschluß und sein Gate mit dem Gate des ersten MOS-Feldeffekttransistors unmittelbar verbunden, während der Drainanschluß des sechsten MOS-Feldeffekttransistors sowohl zur Steuerung des Gates des dritten MOS-Feldeffekttransistors als auch des vierten MOS-Feldeffekttransistors vorgesehen und außerdem mit dem Sourceanschluß des siebenten MOS-Feldeffekttransistors verbunden ist, während das Gate und der Drain des siebenten MOS-Feldeffekttransistors sowohl an dem vom zweiten MOS-Feldeffekttransistor abgewandten Anschluß des Bootstrap-Kondensators als auch an der Source des fünften MOS-Feldeffekttransistors liegt.

Die der soeben gegebenen Definition der Erfindung entsprechende Schaltung eines Eingangssignalpegelwandlers ist in Figur 2 dargestellt.

Bei der Schaltung gemäß Figur 2 ist der Eingang E für das zu verarbeitende TTL-Signal über einen Vorwiderstand R an das Gate des ersten MOS-Feldeffekttransistors T1 sowie an das Gate des zweiten MOS-Feldeffekttransistors T2 gelegt. Dabei liegt der Sourceanschluß des ersten MOS-Transistors T1 am Bezugspotential $V_{ss}$ und sein Drainanschluß an einem Knoten, an welchen auch der Sourceanschluß des dritten MOS-Feldeffekttransistors T3, der Sourceanschluß des zweiten MOS-Feldeffekttransistors T2 und der Sourceanschluß des sechsten MOS-Feldeffekttransistors T6 gelegt ist.

Der Drainanschluß des zweiten MOS-Feldeffekttransistors T2 ist - ähnlich wie beim Transistor t2 in Figur 1 - einerseits an den Signalausgang A des Wandlers als auch über die Source-Drainstrecke eines vierten MOS-Feldeffekttransistors T4 mit dem Versorgungspotential $V_{DD}$ als auch über einen Bootstrap-Kondensator C mit einem weiteren Schaltungsknoten verbunden. An diesen Knoten ist der Drain und das Gate des siebenten MOS-Feldeffekttransistors T7 sowie der Sourceanschluß des fünften MOS-Feld-effekttransistors T5 unmittelbar angeschlossen. Das Gate und der Drainanschluß des fünften MOS-Feldeffekttransistors T5 sind (in Übereinstimmung mit dem Transistor t5 in Fig. 1) an das Versorgungspotential $V_{DD}$ gelegt, so daß dieser Transistor als Widerstand arbeitet. Außerdem liegt der Sourceanschluß des siebenten MOS-Feldeffekttransistors T7 am Drainanschluß des sechsten MOS-Feldeffekttransistors T6 und somit auch am Gate des dritten MOS-Feldeffekttransistors T3 und des vierten MOS-Feldeffekttransistors T4.

Ebenso wie bei der Schaltung nach Figur 1 kann eine Last mit einer wirksamen Kapazität CL für eine kapazitive Verbindung des Signalausgangs A zum bezugspotential $V_{ss}$ sorgen. Sie ist bevorzugt durch die zu beaufschlagende und vorwiegend mit dem Pegelwandler monolithisch zusammengefaßte und über den Pegelwandler zu steuernde n-MOS-Digitalschaltung gegeben.

Die Abweichung der erfindungsgemäßen Schaltung und damit der Schaltung gemäß Figur 2 von der Schaltung gemäß Figur 1 sind somit durch die Anwesenheit des sechsten und des siebenten Transistors T6 und T7 sowie eine andere Steuerung des dritten und des vierten MOS-Feldeffekttransistors gegeben.

Bei der erfindungsgemäßen Schaltung bilden die Transistoren T5, T6 und T7 im Ruhezustand (d.h. $U_E$ = High) einen statischen Spannungsteiler, der sich so dimensionieren läßt, daß einerseits die Spannung am Bootstrap-Kondensator C groß und die Spannung am Gate des vierten MOS-Feldeffekttransistors T4 merklich abgesenkt wird. Andererseits sollte der als Widerstand dienende siebente MOS-Feldeffekttransistor T7 nur eine niedrige $U_T$-Spannung aufweisen, so daß möglichst viel von der Kondensatorspannung im Bootstrap-Fall am Gate von T4 ankommt. (Es ist verständlich, daß anstelle des siebenten MOS-Feldeffekttransistors T7 ggf. auch ein - insbesondere aus Polysilicium bestehender - Widerstand verwendet werden könnte.)

Wird die Spannung des zwischen die Klemme für das Bezugspotential $V_{ss}$ und der Eingangsklemme E zu legenden Signals, also die Spannung $U_E$ kleiner als die Summe aus der Sourcespannung von T6 und $U_T$, so steigt die Gatespannung von T4 auf den Wert der Spannung $U_C$ am Bootstrap-Kondensator C an. Hierdurch bedingt ist ein Ansteigen der Ausgangsspannung $U_A$, wodurch über die Bootstrap-Kapazität C die Gatespannung von T4 überhöht wird. Dies bedeutet, daß die dynamischen Eigenschaften des Pegelwandlers gemäß Fig. 2 keine merkliche Beeinträchtigung erleiden.

Für eine vergleichende dynamische Metzwerk-Simulation der erfindungsgemäßen Schaltung wurde das W/L-Verhältnis der Transistoren T1 - T7 wie folgt bemessen: T1 = 50, T2 = 50, T3 = 5, T4 = 10, T5 = 18, T6 = 6, T7 = 1. Die zweckmäßiger Weise durch einen MOS-Kondensator gegebene Bootstrap-Kapazität C wurde auf einen Wert von 350 fF bemessen. Für die Simulation wurde eine Lastkapazität CL von 0,5 pF angenommen. Die Klemme für $V_{DD}$ lag in üblicher Weise auf + 5V (für n-Kanaltechnik). Der Transistor T7 hat aus dem oben angegebenen Grund eine niedrigere Einsatzspannung $U_T$ als die übrigen Transistoren des Pegelwandlers.

Figur 3 zeigt den unter den angegebenen Bedingungen erhaltenen zeitlichen Verlauf der Eingangspannung $U_E$, der Ausgangsspannung $U_A$ und des Versorgungsstroms $I_{DD}$.

Soll die in Figur 1 dargestellte bekannte Schaltung bezüglich ihres dynamischen Verhaltens an die Schaltung gemäß Figur 2 angeglichen werden, so muß das W/L-Verhältnis von t1 = 90 (wobei t1 im Interesse der dort erforderlichen $U_T$-Erhöhung eine größere Gatelänge haben müßte), von t2 = 125, von t3 = 7,5, von t4 = 5 und von t5 = 1 sein und die Bootstrap-Kapazität C auf 250 fF eingestellt werden. Bei gleicher Lastkapazität CL, wie sie zur Erzielung des in Fig. 3 dargestellten Verhaltens verwendet wurde, erhält man dann das ebenfalls in Fig. 3 dargestellte und durch die Kurve $U_{A\ a}$ gegebene Verhalten aufgrund des am Signaleingang E der Schaltung gemäß Fig. 1 liegenden TTL-Pegels.

Aus den unterschiedlichen Größen der Transistoren, an deren Gate in den beiden verglichenen Fällen die TTL-Eingangsspannung $U_E$ angelegt wird, erkennt man ohne weiteres den Unterschied zwischen den Eingangskapazitäten der beiden Schaltungen. (Mit den der Simulation zugrunde gelegten Transistorparametern und Größen ergibt sich ein Verhältnis von 400 fF/ 1200 fF zugunsten der erfindungsgemäßen Schaltung.)

Hinsichtlich der mit $I_{DD\ a}$ und $I_{DD\ n}$ bezeichneten Kurven in Fig. 3 ist im Falle der Kurve $I_{DD\ a}$ der Stromverlauf der bekannten Schaltung und im Falle der Kurve $I_{DD\ n}$ derStromverlauf der erfindungsgemäßen Schaltung dargestellt.

Man erkennt aus Figur 3, daß bei gleicher Flankensteilheit der Ausgangsspannungen der alten Schaltung gemäß Fig. 1 und der erfindungsgemäßen Schaltung gemäß Fig. 3 die Ruhestromaufnahme der erfindungsgemäßen Version um etwa 2/3 (d.h. 0,27 mA : 0,81 mA) im Vergleich zur bekannten Schaltung niedriger ist. Außerdem liegt bei der Schaltung gemäß der Erfindung der am Ausgang A erreichte Low-Pegel niedriger als bei der alten Schaltung.

**Patentansprüche**

1. Eingangssignalpegelwandler für eine MOS-Digitalschaltung, der zusammen mit der MOS-Digitalschaltung in n-Kanal-MOS-Technik aufgebaut ist, bei der der durch ein TTL-Signal beaufschlagte Signaleingang (E) zur Steuerung eines ersten und eines zweiten MOS-Feldeffekttransistors (T1, T2) dient, wobei der Sourceanschluß des ersten MOS-Feldeffekttransistors (T1) an dem das Bezugspotential führenden Versorgungsanschluß (VSS) und sein Drainanschluß einerseits am Sourceanschluß des zweiten MOS-Feldeffekttransistors (T2) liegt und andererseits über die Source-Drain-Strecke eines dritten MOS-Feldeffekttransistors (T3) mit dem das Versorgungspotential liefernden Versorgungsanschluß (VDD) verbunden ist, bei dem außerdem der Drainanschluß des zweiten MOS-Feldeffekttransistors (T2) einerseits den Signalausgang (A) des Wandlers bildet und andererseits über die Parallelschaltung eines vierten MOS-Feldeffekttransistors (T4) mit der Reihenschaltung eines Bootstrap-Kondensators (C) und eines als Widerstand geschalteten fünften MOS-Feldeffekttransistors (T5) mit dem das Versorgungspotential liefernden Versorgungsanschluß (VDD) verbunden ist und bei dem schließlich der Signalausgang (A) unmittelbar mit dem Signaleingang der das gleiche Bezugspotential und das gleiche Versorgungspotential wie der Signalpegelwandler verwendenden MOS-Digitalschaltung verbunden ist,

   **dadurch gekennzeichnet,**

   daß ein sechster und ein siebenter MOS-Feldeffekttransistor (T6, T7) vorgesehen sind und daß dabei der Sourceanschluß des sechsten MOS-Feldeffekttransistors (T6) mit dem Drainanschluß und sein Gate mit dem Gate des ersten MOS-Feldeffekttransistors (T1) unmittelbar verbunden ist, während der Drainanschluß des sechsten MOS-Feldeffekttransistors (T6) sowohl zur Steuerung des Gates des dritten (T3) als auch des vierten MOS-Feldeffekttransistors (T4) vorgesehen und außerdem mit dem Sourceanschluß des siebenten MOS-Feldeffekttransistors (T7) verbunden ist, während das Gate und der Drain des siebenten MOS-Feldeffekttransistors (T7) sowohl an dem vom zweiten MOS-Feldeffekttransistors (T2) abgewandten Anschluß des Bootstrap-Kondensators (C) als auch an der Source des fünften MOS-Feldeffekttransistors (T5) liegen.

2. Pegelwandler nach Anspruch 1, dadurch gekennzeichnet, daß er mit der von ihm beaufschlagten digitalen MOS-Schaltung monolithisch zusammengefaßt ist.

**Claims**

1. Input level converter for a digital MOS circuit which is constructed together with the digital MOS circuit in n-channel MOS technology, in which the signal input (E) receiving a TTL signal is used for controlling a first and a second MOS field-effect transistor (T1, T2), the source terminal of the first MOS field-effect transistor (T1) being connected to the supply terminal (VSS) carrying the reference potential, and its drain terminal on the one hand being connected to the source terminal of the second MOS field-effect transistor (T2) and on the other hand being connected via the source-drain path of a third MOS field-effect transistor (T3) to the supply terminal (VDD) providing the supply potential, in which, furthermore, the drain terminal of the second MOS field-effect transistor (T2) on the one hand forms the signal output (A) of the converter and on the other hand is connected to the supply terminal (VDD) providing the supply potential, via the parallel circuit of a fourth MOS field-effect transistor (T4) with the series circuit of a bootstrap capacitor (C) and a fifth MOS field-effect transistor (T5), connected as a resistor, and in which, finally, the signal output (A) is connected directly to the signal input of the digital MOS circuit which uses the same reference potential and the same supply potential as the signal level converter, characterised in that a sixth and a seventh MOS field-effect transistor (T6, T7) are provided, and in that the source terminal of the sixth MOS field-effect transistor (T6) is thereby connected directly to the drain terminal, and its gate is connected directly to the gate of the first MOS field-effect transistor (T1), while the drain terminal of the sixth MOS field-effect transistor (T6) is provided both for controlling the gate of the third (T3) and of the fourth MOS field-effect transistor (T4) and, furthermore, is connected to the source terminal of the seventh MOS field-effect transistor (T7), while the gate and the drain of the seventh MOS field-effect transistor (T7) are connected both to the terminal of the bootstrap capacitor (C) remote from the second MOS field-effect transistor (T2) and to the source of the fifth MOS field-effect transistor (T5).

2. Level converter according to Claim 1, characterised in that it is combined monolithically with the digital MOS circuit on which it acts.

**Revendications**

1. Convertisseur de niveau du signal d'entrée prévu pour un circuit numérique MOS et qui est formé, conjointement avec le circuit numérique MOS, selon la technique MOS à canal n, et dans lequel l'entrée (E) des signaux, qui est chargée par un signal TTL, sert à commander des premier et second transistors à effet de champ MOS (T1,T2), la borne de source du premier transistor à effet de champ MOS (T1) étant raccordée à la borne d'alimentation (VSS) appliquant le potentiel de référence, et sa borne de drain étant raccordée d'une part à la borne de source du second transistor à effet de champ (T2) et d'autre part, par l'intermédiaire de la voie source-drain d'un troisième transistor à effet de champ MOS (T3), à la borne d'alimentation (VDD) délivrant le potentiel d'alimentation, et dans lequel en outre la borne de drain du second transistor à effet de champ MOS (T3) d'une part forme la sortie (A) des signaux du convertisseur et d'autre part est raccordée à la borne d'alimentation (VDD) délivrant le potentiel d'alimentation, par l'intermédiaire du montage en parallèle formé d'un quatrième transistor à effet de champ (T4) et du circuit série formé d'un condensateur autoélévateur (C) et d'un cinquième transistor à effet de champ MOS (T5) branché en tant que résistance, et dans lequel enfin la sortie (A) des signaux est raccordée directement à l'entrée des signaux du circuit numérique MOS qui utilise le même potentiel de référence et le même potentiel d'alimentation que le convertisseur de niveau de signal, caractérisé par le fait qu'il est prévu un sixième et un septième transistors à effet de champ MOS (T6,T7) et que la borne de source du sixième transistor à effet de champ (T6) est raccordée directement à la borne de drain et que sa grille est raccordée directement à la grille du premier transistor à effet de champ MOS (T1), tandis que la borne de drain du sixième transistor à effet de champ MOS (T6) est prévue aussi bien pour commander la grille du troisième transistor à effet de champ MOS (T3) que du quatrième transistor à effet de champ MOS (T4) et est en outre raccordée à la borne de source du septième transistor à effet de champ MOS (T7), tandis que la grille et le drain du septième transistor à effet de champ (T7) sont appliqués aussi bien à la borne, située à l'opposé du second transistor à effet de champ MOS (T2), du condensateur auto-élévateur (C) qu'à la source du cinquième transistor à effet de champ MOS (T5).

2. Convertisseur de niveau suivant la revendication 1, caractérisé par le fait qu'il est réuni sous forme monolithique au circuit MOS numérique chargé par ce convertisseur de niveau.

# FIG 1

# FIG 2

# FIG 3